**Europäisches Patentamt**

**European Patent Office**

**Office européen des brevets**

(19)

(11) Veröffentlichungsnummer: **0 429 913 A2**

# (12) EUROPÄISCHE PATENTANMELDUNG

(21) Anmeldenummer: **90121391.8**

(22) Anmeldetag: **08.11.90**

(51) Int. Cl.5: **H03D 7/12**

(30) Priorität: **01.12.89 DE 3939740**

(43) Veröffentlichungstag der Anmeldung:
**05.06.91 Patentblatt 91/23**

(84) Benannte Vertragsstaaten:
**AT CH DE ES FR GB IT LI Patentblatt**

(71) Anmelder: **TELEFUNKEN electronic GmbH**
**Theresienstrasse 2**
**W-7100 Heilbronn(DE)**

(72) Erfinder: **Küspert, Ludwig**
**Austrasse 7**
**W-8079 Hofstetten(DE)**
Erfinder: **Schrotberger, Franz**
**Schulstrasse 5**
**W-8074 Gaimersheim(DE)**
Erfinder: **Schultz, Georg**
**Schiessstättweg 17**
**W-8069 Geisenfeld(DE)**

(74) Vertreter: **Maute, Hans-Jürgen, Dipl.-Ing.**
**TELEFUNKEN electronic GmbH**
**Theresienstrasse 2**
**W-7100 Heilbronn(DE)**

(54) **Mischstufe.**

(57) Die Erfindung betrifft eine Mischstufe mit einem mit derselben verbundenen Arbeitswiderstand zur Übertragung eines Zf-Signales zum nachgeschalteten Zf-Verstärker. Erfindungsgemäß ist der Arbeitswiderstand aus einer Reihenschaltung eines Tiefpasses, eines Sperrkreises und eines Hochpasses aufgebaut.

EP 0 429 913 A2

## MISCHSTUFE

Die Erfindung betrifft eine Mischstufe gemäß dem Oberbegriff des Patentanspruches 1.

Die Erfindung geht aus von einer Mischstufe mit einem Mischstufenarbeitswiderstand, der entweder als Parallelschwingkreis, beispielsweise im Zwischenfrequenzteil eines FM-Empfängers auf die Zwischenfrequenz abgestimmt ist, oder als zwei- oder mehrkreisiges Bandfilter, beispielsweise im Zwischenfrequenzteil eines Fernsehempfängers die Bild- und Tonträgerzwischenfrequenz ausfiltert, aufgebaut ist.

Ein Nachteil eines solchen mit einem Einzelkreis oder einem Bandfilter aufgebauten Mischstufenarbeitswiderstandes besteht in der Durchführung eines Abgleichs der mit diesem Arbeitswiderstand aufgebauten Mischstufe.

Demzufolge besteht die Aufgabe der vorliegenden Erfindung darin, einen Mischstufenarbeitswiderstand einer Mischstufe der eingangs genannten Art anzugeben, der den o.g. Nachteil nicht mehr aufweist. Die Lösung dieser Aufgabe ist durch die kennzeichnenden Merkmale des Patentanspruches 1 gegeben.

Demnach wird erfindungsgemäß der Arbeitswiderstand einer Mischstufe als Bandpaßfilter aufgebaut, weshalb ein Abgleich auf eine entsprechende Zwischenfrequenz entfällt. Ferner wird aufgrund des Sperrkreises ein versteilerter Dämpfungsanstieg des Tiefpasses im Bereich dessen Grenzfrequenz erzielt, wodurch ein Dämpfungspol entsteht, der unerwünschte Nachbartonträgerzwischenfrequenzen unterdrückt.

Vorteilhafte Ausgestaltungen des erfindungsgemäßen Mischstufenarbeitswiderstandes sind den Ansprüchen 2 bis 10 entnehmbar.

Die Erfindung soll im folgenden anhand von Ausführungsbeispielen in Verbindung mit den Zeichnungen näher erläutert werden. Hierbei zeigen:

Figur 1  ein Blockschaltbild einer Mischstufe mit einem Ausführungsbeispiel eines erfindungsgemäßen Mischstufenarbeitswiderstandes,

Figur 2  ein Schaltbild des Ausführungsbeispieles gemäß Figur 1,

Figur 3a  die Durchgangscharakteristik der Filterelemente der Ausführungsbeispiele gemäß den Figuren 1 und 2, und

Figur 3b  die Durchgangscharakteristik des erfindungsgemäßen Mischstufenarbeitswiderstandes gemäß den Figuren 1 und 2.

In den Zeichnungen sind einander entsprechende Teile und Bauelemente mit den gleichen Bezugzeichen versehen.

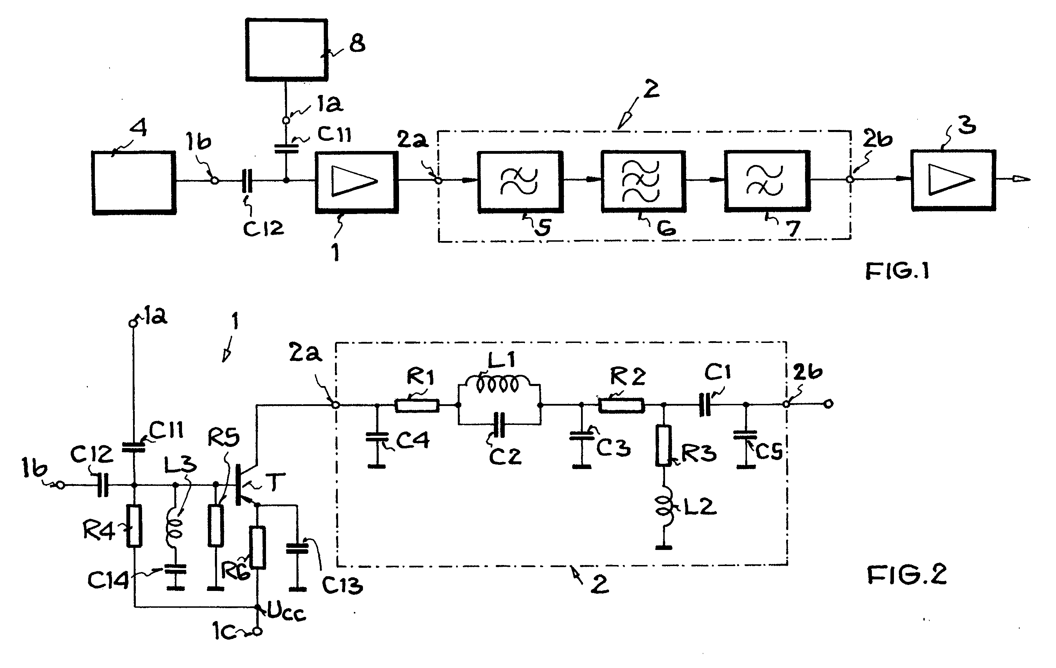

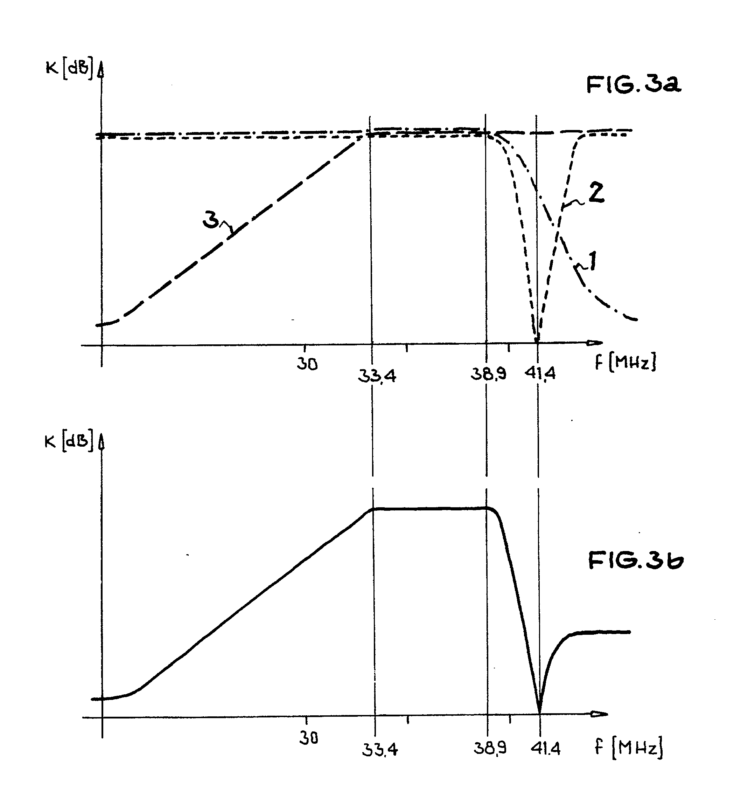

Gemäß Figur 1 ist eine Mischstufe 1 mit einem Mischstufenarbeitswiderstand 2 verbunden, wobei das von einem Oszillator 8 erzeugte Oszillatorsignal über einen Anschlußkontakt 1a und einem Koppelkondensator C11 und das Hf-Signal einer Vorstufe 4 über einen Anschlußkontakt 1b und einem weiteren Koppelkondensator C12 dem Eingang der Mischstufe 1 zugeführt werden. Der Mischstufenarbeitswiderstand 2 besteht aus der Reihenschaltung eines Tiefpasses 5, eines Sperrkreises 6 und eines Hochpasses 7, wobei ein Anschlußkontakt 2a zum Tiefpaß 5 mit dem Ausgang der Mischstufe 1 und ein Anschlußkontakt 2b, der den Ausgang des Hochpasses 7 darstellt. Dieser Anschlußkontakt 2b ist an den Eingang eines nachgeschalteten Zwischenfrequenzverstärkers 3 angeschlossen. Die Figur 3a zeigt die Filterkurven der den Mischstufenarbeitswiderstand 2 gemäß der Figur 1 aufbauenden Filterelemente 5, 6 und 7, wobei mit den Bezugzeichen 1, 2 und 3 die Durchlaßkurven des Tiefpasses 5, des Sperrkreises 6 und des Hochpasses 7 bezeichnet sind. Die Grenzfrequenz des Tiefpaßfilters 5 beträgt ca. 40 MHz, während diejenige des Hochpaßfilters 7 ca. 32 MHz beträgt. Der Sperrkreis 6 ist auf eine Resonanzfrequenz von $\geq$ 41,4 MHz eingestellt. Die aus den einzelnen Filterkurven gemäß Figur 3a sich ergebende Durchlaßcharakteristik des Mischstufenarbeitswiderstandes 2 zeigt die Figur 3b, wonach der Dämpfungsanstieg im Bereich der oberen Grenzfrequenz von ca. 40 MHz wesentlich steiler ist im Vergleich zu der Filterkurve 1 gemäß Figur 3a. Diese Durchgangscharakteristik gemäß der Figur 3b entspricht der Durchlaßkurve eines Bandpasses mit einer unteren Grenzfrequenz von ca. 32 MHz und einer oberen Grenzfrequenz von ca. 40 MHz wobei zusätzlich ein Dämpfungspol bei 41,4 MHz vorhanden ist.

Die Figur 2 zeigt die Mischstufe 1 mit deren Arbeitswiderstand 2 gemäß der Figur 1 in einer konkreten Schaltungsausführung. Die Basis-Elektrode eines pnp-Transistors T ist über einen Koppelkondensator C11 mit dem Anschlußkontakt 1a und über einen Koppelkondensator C12 mit dem Anschlußkontakt 1b verbunden, wobei über diese beiden Anschlußkontakte 1a und 1b wie schon bei der Erläuterung des Blockschaltbildes gemäß Figur 1 dargelegt wurde, das Oszillatorsignal und das HF-Signal zugeführt wird. Ferner ist die Basis-Elektrode und die Emitter-Elektrode des Transistors T über eine Reihenschaltung zweier Widerstände R4 und R6 verbunden, wobei der Verbindungspunkt dieser beiden Widerstände einen Anschlußkontakt 1c bildet, an die eine Betriebsspannung $U_{CC}$ angelegt wird. Außerdem verbindet sowohl ein aus einer Spule L3 und einem Kondensator C14 aufgebauter Reihenschwingkreis als auch ein Widerstand R5 die Basis-Elektrode dieses Transistors T5 mit dem Bezugspotential der Schaltung. Schließlich liegt die Emitter-Elektrode dieses Transistors T über einen Kondensator C13 ebenfalls auf dem Bezugspotential der Schaltung, während dessen Kollektor-Elektrode mit dem Anschlußkontakt 2a des Mischstufenarbeitswiderstandes 2 verbunden ist.

Eine Reihenschaltung aus einem ersten Widerstand R1, einer ersten Spule L1, einem zweiten Widerstand R2 und einem ersten Kondensator C1 verbindet den Anschlußkontakt 2a mit dem Anschlußkontakt 2b des Mischstufenarbeitswiderstandes 2. Weiterhin ist zur Bildung eines Sperrkreises der ersten Spule L1 ein zweiter Kondensator C2 parallel geschaltet, wobei gleichzeitig zur Bildung eines -Tiefpasses der ersten Spule L1 ein dritter Kondensator C3 gegen das Bezugspotential nachgeschaltet und ein vierter Kondensator C4 dem ersten Widerstand R1 ebenfalls gegen das Bezugspotential vorgeschaltet ist. Ferner ist der Verbindungspunkt des zweiten Widerstandes R2 mit dem ersten Kondensator C1 über eine Reihenschaltung aus einem dritten Widerstand R3 und einer zweiten Spule L2 mit dem Bezugspotential der Schaltung verbunden, wodurch zusammen mit dem ersten Kondensator C1 ein Hochpaß gebildet wird. Ein mit dem Anschlußkontakt 2b verbundener fünfter Kondensator C5 bildet zusammen mit dem ersten Kondensator C1 einen kapazitiven Spannungsteiler.

Die Durchgangscharakteristik des Mischstufenarbeitswiderstandes 2 der Figur 2 entspricht derjenigen, die in Figur 3b dargestellt ist. Die drei Widerstände R1, R2 und R3 sind niederohmig und bewirken eine Linearisierung der Durchgangscharakteristik.

## Ansprüche

1. Mischstufe (1) mit einem mit derselben verbundenen Arbeitswiderstand (2) zur Übertragung eines ZF-Signales zum nachgeschalteten ZF-Verstärker (3), dadurch gekennzeichnet, daß der Arbeitswiderstand (2) aus einer Reihenschaltung eines Tiefpasses (5), eines Sperrkreises (6) und eines Hochpasses (7) aufgebaut ist.

2. Mischstufe nach Anspruch 1, dadurch gekennzeichnet, daß der Tiefpaß (5) als Tiefpaß--Filter aufgebaut ist.

3. Mischstufe nach Anspruch 1 oder 2, dadurch gekennzeichnet, daß dem ZF-Verstärker (3) ein kapazitiver Spannungsteiler (C1, C5) vorgeschaltet ist.

4. Mischstufe nach einem der vorangehenden Ansprüche, dadurch gekennzeichnet, daß im Signalweg wenigstens ein ohmscher Widerstand (R1, R2, R3) geschaltet ist.

5. Mischstufe nach einem der vorangehenden Ansprüche, dadurch gekennzeichnet, daß der Tiefpaß (5) eine Grenzfrequenz von ca. 40 MHz aufweist.

6. Mischstufe nach einem der Ansprüche 1 bis 4, dadurch gekennzeichnet, daß der Sperrkreis (6) eine Resonanzfrequenz von $\geq$ 41,4 MHz aufweist.

7. Mischstufe nach einem der Ansprüche 1 bis 4, dadurch gekennzeichnet, daß der Hochpaß (7) eine Grenzfrequenz von ca. 32 MHz aufweist.

8. Mischstufe nach einem der vorangehenden Ansprüche, dadurch gekennzeichnet, daß der Arbeitswiderstand (2) eine erste Spule (L1) aufweist, die sowohl dem Tiefpaß (5) als auch dem Sperrkreis (6) zugeordnet ist.

9. Mischstufe nach einem der vorangehenden Ansprüche, dadurch gekennzeichnet, daß die Mischstufe (1) ein pnp-Transistor (T) ist, und daß dessen Kollektor-Elektrode mit dem Arbeitswiderstand (2) verbunden ist.

10. Mischstufe nach Anspruch 9, dadurch gekennzeichnet, daß der Arbeitswiderstand (2) aus einer Reihenschaltung eines ersten Widerstandes (R1), einer ersten Spule (L1), eines zweiten Widerstandes (R2) und eines ersten Kondensators (C1) in der Reihenfolge dieser Aufzählung aufgebaut ist, wobei der erste Widerstand (R1) mit der Kollektor-Elektrode des Transistors (T) und der erste Kondensator (C1) mit dem Eingang des Zf-Verstärkers (3) verbunden sind, daß ein zweiter Kondensator (C2) zur ersten Spule (L1) parallel geschaltet ist, daß der Verbindungspunkt der ersten Spule (L1) mit dem zweiten Widerstand (R2) über einen dritten Kondensator (C3) mit dem Bezugspotential der Schaltung verbunden ist, daß der Verbindungspunkt des zweiten Widerstandes (R2) mit dem ersten Kondensator (C1) über eine Reihenschaltung aus einem dritten Widerstand (R3) und einer zweiten Spule (L2) mit dem Bezugspotential der Schaltung verbunden ist, und daß sowohl der mit der Kollektor-Elektrode des Transistors (T) verbundene Anschluß des ersten Widerstandes (R1) über einen vierten Kondensator (C4) als auch der mit dem Zf-Verstärker (3) verbundene Anschluß des ersten Kondensators (C1) über einen fünften Kondensator (C5) auf dem Bezugspotential der Schaltung liegt.

EP 0 429 913 A2

8

1a

C11

2

4  1b  2a  2b  3

C12

5  6  7

1

**FIG.1**

1a

1

2a  R1  L1  R2  C1  2b

C11

C12  R5

1b  L3  T  C4  C2  C3  R3  C5

R4

C14  R6  L2

C13

1c  Ucc

**FIG.2**

FIG.3a

FIG.3b